# EUROPEAN PATENT APPLICATION

(11) **EP 3 457 440 A1**
(43) Date of publication of application: **20.03.2019**
(21) Application number: 18157871.7
(22) Date of filing: 21.02.2018
(51) Int. Cl.: H01L 29/78, H01L 29/06

(54) **SEMICONDUCTOR DEVICE**

(30) Priority: 15.09.2017 JP 2017178413
(71) Applicant: Kabushiki Kaisha Toshiba, Minato-ku, Tokyo 105-8001 (JP); Toshiba Electronic Devices & Storage Corporation, Tokyo, 105-0023 (JP)
(72) Inventor: ONO, Syotaro, Tokyo, 105-0023 (JP); OHTA, Hiroshi, Tokyo, 105-0023 (JP); ICHIJO, Hisao, Tokyo, 105-0023 (JP); YAMASHITA, Hiroaki, Tokyo, 105-0023 (JP)
(74) Representative: Hoffmann Eitle

(57) **Abstract**

A semiconductor device of an embodiment includes a semiconductor layer having first and second plane, a first semiconductor region of a first conductivity type, second semiconductor regions of a second conductivity type between the first semiconductor region and the first plane, third semiconductor regions of a first conductivity type provided between the first semiconductor region and the first plane and provided between the second semiconductor regions, a fourth semiconductor region provided between the second semiconductor regions and the first plane, and having a higher second conductivity-type impurity concentration than the second semiconductor regions, a fifth semiconductor region of a first conductivity type between the fourth semiconductor region and the first plane, a sixth semiconductor region provided between the second semiconductor regions and the fourth semiconductor region, and having a higher electric resistance per unit depth than the second semiconductor regions, a gate electrode, and a gate insulating film.

## Description

### CROSS-REFERENCE TO RELATED APPLICATION

This application is based upon and claims the benefit of priority from Japanese Patent Application No. 2017-178413, filed on September 15, 2017, the entire contents of which are incorporated herein by reference.

### FIELD

Embodiments described herein relate generally to a semiconductor device.

### BACKGROUND

There is a metal oxide semiconductor field effect transistor (MOSFET) having a super junction structure (hereinafter also referred to as "SJ structure") in which an n-type region and a p-type region are alternately arranged in a semiconductor layer. The MOSFET having the SJ structure achieves both high breakdown voltage and low on-resistance. In the SJ structure, an n-type impurity amount contained in the n-type region and a p-type impurity amount contained in the p-type region are made equal to create a pseudo non-doped region to realize the high breakdown voltage. At the same time, the impurity concentration of the n-type region can be made high, and thus the low on-resistance can be realized.

However, in the MOSFET having the SJ structure, noise at the time of a switching operation may be increased. When the n-type region and the p-type region are rapidly depleted at the time of turning off the MOSFET, a drain-source capacitance (Cds) and a gate-drain capacitance (Cgd) are rapidly decreased. Therefore, a temporal change amount (dv/dt) of a drain voltage and a temporal change amount (di/dt) of a drain current become large. As a result, counter electromotive force due to parasitic inductance and displacement current due to parasitic capacitance are generated, and the noise at the time of the switching operation is increased.

If the noise at the time of the switching operation is increased, surrounding electronic devices and the human body may be adversely affected. Therefore, suppression of the noise at the time of the switching operation of the MOSFET having the SJ structure is required

### BRIEF DESCRIPTION OF THE DRAWINGS

FIG. 1 is a schematic sectional view of a semiconductor device of a first embodiment;
FIGS. 2A and 2B are schematic plan views of the semiconductor device of the first embodiment;
FIG. 3 is a schematic view illustrating distribution of p-type impurity concentration of the semiconductor device of the first embodiment;
FIG. 4 is a schematic sectional view of a semiconductor device of a comparative example;
FIGS. 5A and 5B are explanatory diagrams of problems of the semiconductor device of the first embodiment;
FIGS. 6A and 6B are explanatory diagrams of functions and effects of the semiconductor device of the first embodiment;
FIG. 7 is an explanatory diagram of functions and effects of the semiconductor device of the first embodiment;
FIG. 8 is a schematic sectional view of a semiconductor device of a second embodiment;
FIG. 9 is a schematic sectional view of a semiconductor device of a third embodiment;
FIG. 10 is a schematic sectional view of a semiconductor device of a fourth embodiment;
FIG. 11 is a schematic sectional view of a semiconductor device of a fifth embodiment;
FIG. 12 is a schematic sectional view of a semiconductor device of a sixth embodiment;
FIG. 13 is a schematic sectional view of a semiconductor device of a seventh embodiment; and
FIG. 14 is a schematic sectional view of a semiconductor device of an eighth embodiment.

### DETAILED DESCRIPTION

Hereinafter, embodiments of the present disclosure will be described with reference to the drawings. Note that, in the following description, the same or similar members and the like are denoted with the same reference numeral, and description of a member or the like, which has been once described, is omitted as appropriate.

In addition, in the following description, relative high and low levels of the impurity concentration in each conductivity type may be expressed by the notation of n⁺, n, n⁻, n⁻⁻, p⁺, p, p⁻, and p⁻⁻. That is, n⁺ has a relatively higher n-type impurity concentration than n, n⁻ has a relatively lower n-type impurity concentration than n, and n⁻⁻ has a relatively lower n-type impurity concentration than n⁻.

Further, p⁺ has a relatively higher p-type impurity concentration than p, p⁻ has a relatively lower p-type impurity concentration than p, and p⁻⁻ has a relatively lower p-type impurity concentration than p⁻. Note that n⁺-type, n⁻-type, and n⁻⁻-type may be simply described as n-type, and p⁺-type, p⁻-type, and p⁻⁻-type may be simply described as p-type.

In the present specification, the p-type impurity concentration means a net p-type impurity concentration. The net p-type impurity concentration is a concentration obtained by subtracting an actual n-type impurity concentration from an actual p-type impurity concentration of a semiconductor region. Similarly, in the present specification, the n-type impurity concentration means a net n-type impurity concentration. The net n-type impurity concentration is a concentration obtained by subtracting an actual p-type impurity concentration from an actual n-type impurity concentration of a semiconductor region.

### (First Embodiment)

A semiconductor device of a first embodiment includes a semiconductor layer having a first plane and a second plane; a first semiconductor region of a first conductivity type provided in the semiconductor layer; second semiconductor regions of a second conductivity type provided between the first semiconductor region and the first plane; third semiconductor regions of the first conductivity type provided between the first semiconductor region and the first plane, and the third semiconductor regions provided between the second semiconductor regions, the third semiconductor regions and the second semiconductor regions being alternately arranged; a fourth semiconductor region of the second conductivity type provided between at least one of the second semiconductor regions and the first plane, the fourth semiconductor region having at least a part provided in contact with the first plane, and the fourth semiconductor region having a higher second conductivity-type impurity concentration than the second semiconductor regions; a fifth semiconductor region of the first conductivity type provided between the fourth semiconductor region and the first plane; a sixth semiconductor region provided between the at least one of the second semiconductor regions and the fourth semiconductor region, and the sixth semiconductor region having a higher electric resistance per unit depth than the second semiconductor regions; a gate electrode; and a gate insulating film provided between the at least part of the fourth semiconductor region and the gate electrode.

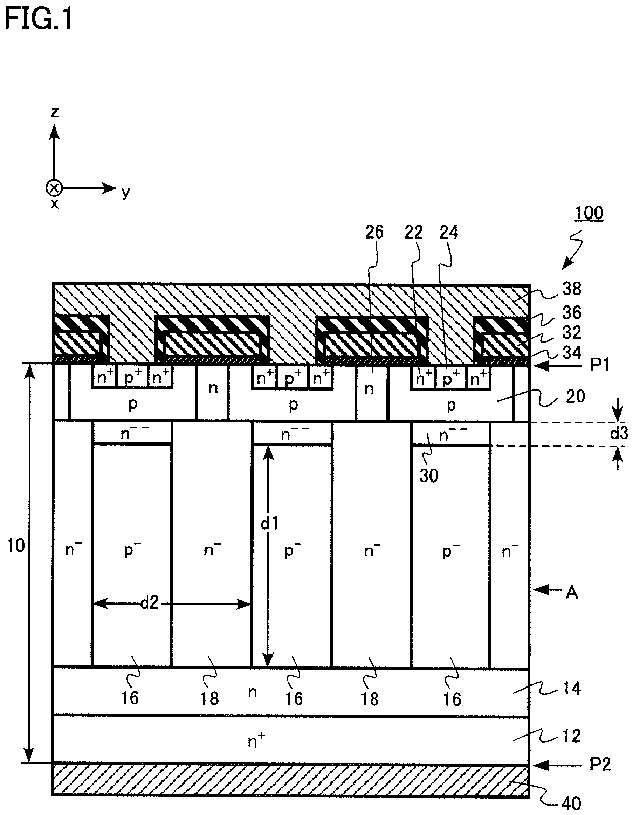

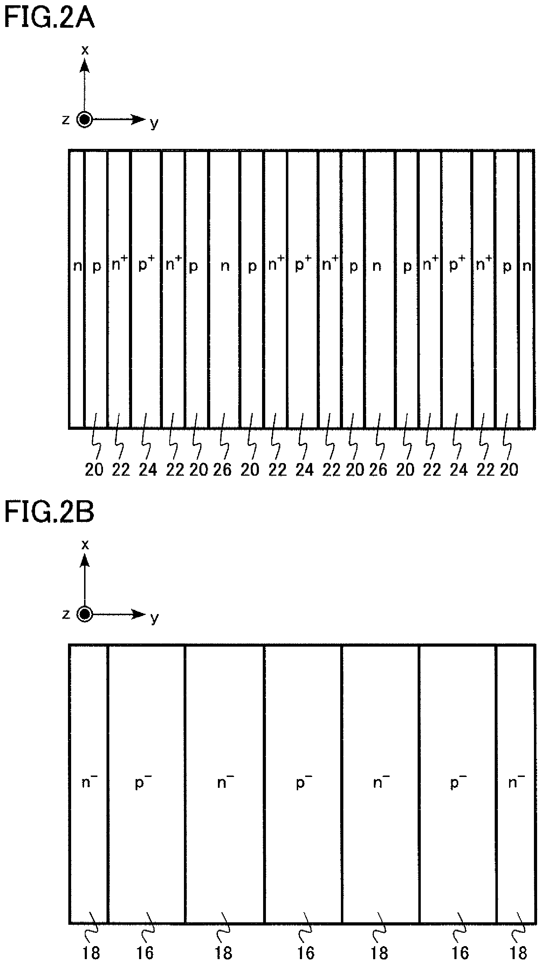

FIG. 1 is a schematic sectional view of the semiconductor device of the first embodiment. FIGS. 2A and 2B are schematic plan views of the semiconductor device of the first embodiment. FIGS. 2A and 2B are sectional views of a plane parallel to an xy plane. FIG. 2A illustrates a pattern of the semiconductor regions at a position of an upper plane (P1 in FIG. 1) of the semiconductor device. FIG. 2B illustrates a pattern of the semiconductor regions at a position A in FIG. 1 of the semiconductor device.

The semiconductor device of the first embodiment is a vertical MOSFET 100 having an SJ structure. The MOSFET 100 is a planar gate-type MOSFET having a MOS structure on a surface of the semiconductor layer. The MOSFET 100 is a high breakdown voltage MOSFET having a breakdown voltage of 250 V or more, for example.

The MOSFET 100 is an n-type MOSFET using electrons as carriers. In the first embodiment, the first conductivity type is an n type and the second conductivity type is a p type.

The MOSFET 100 includes a semiconductor layer 10, an n⁺-type drain region 12 (first semiconductor region), an n-type buffer region 14, a p⁻-type p pillar region 16 (second semiconductor region), an n⁻-type n pillar region 18 (third semiconductor region), a p-type base region 20 (fourth semiconductor region), an n⁺-type source region 22 (fifth semiconductor region), a p⁺-type contact region 24, an n-type JFET region 26, an n⁻⁻-type high-resistance region 30 (sixth semiconductor region), a gate electrode 32, a gate insulating film 34, an interlayer insulating film 36, a source electrode 38, and a drain electrode 40.

The semiconductor layer 10 has a first plane (P1 in FIG. 1) and a second plane (P2 in FIG. 1) facing the first plane. In FIG. 1, the first plane is an upper plane in the figure and the second plane is a lower plane in the figure.

The semiconductor layer 10 is made of, for example, single crystal silicon.

The n⁺-type drain region 12 is provided in the semiconductor layer 10. The drain region 12 is provided in contact with the second plane of the semiconductor layer 10.

The drain region 12 contains n-type impurities. The n-type impurities are, for example, phosphorus (P). The n-type impurity concentration is, for example, from 1 × 10¹⁸ cm⁻³ to 1 × 10²¹ cm⁻³, both inclusive.

The drain region 12 is electrically connected to the drain electrode 40. The drain region 12 has a function to reduce a contact resistance between the semiconductor layer 10 and the drain electrode 40.

The n-type buffer region 14 is provided in the semiconductor layer 10. The buffer region 14 is provided on the drain region 12.

The buffer region 14 contains n-type impurities. The n-type impurities are, for example, phosphorus (P).

The n-type impurity concentration of the buffer region 14 is lower than the n-type impurity concentration of the drain region 12. The n-type impurity concentration is, for example, from 1 × 10¹⁵ cm⁻³ to 1 × 10¹⁷ cm⁻³, both inclusive.

The buffer region 14 has a function to suppress a depletion layer extending at the time of an off operation of the MOSFET 100.

A plurality of p⁻-type p pillar regions 16 is provided between the drain region 12 and the first plane. The p pillar region 16 is provided on the buffer region 14.

The p pillar region 16 extends in an x direction, as illustrated in FIG. 2B. The p pillar region 16 has a flat plate shape parallel to an xz plane. A distance (d1 in FIG. 1) from an end portion of the p pillar region 16 on a side of the first plane to an end portion of the p pillar region 16 on a side of the second plane is, for example, 20 µm or more.

The p pillar region 16 contains p-type impurities. The p-type impurities are, for example, boron (B). The p-type impurity concentration is, for example, from 1 × 10¹⁵ cm⁻³ to 8 × 10¹⁶ cm⁻³, both inclusive.

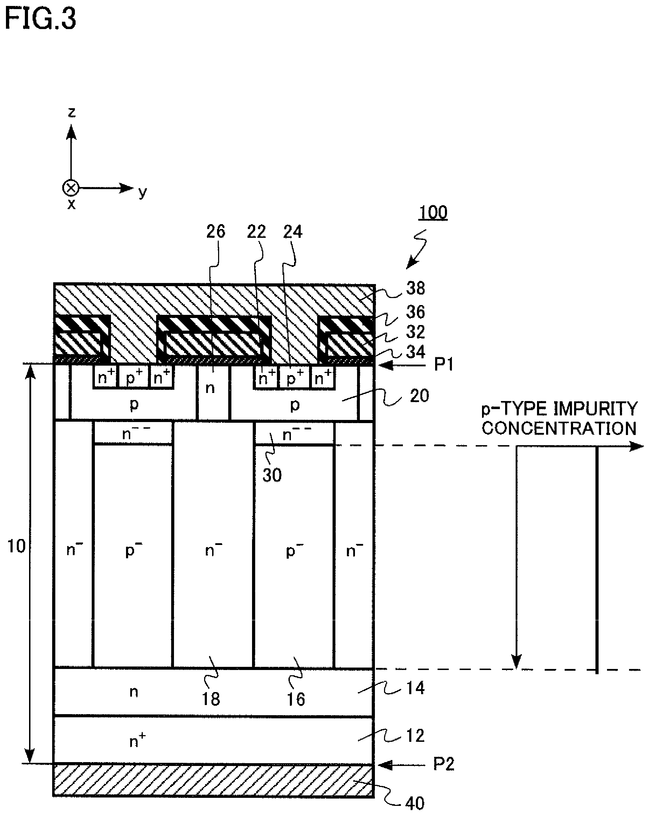

FIG. 3 is a schematic view illustrating distribution of p-type impurity concentration of the semiconductor device of the first embodiment. FIG. 3 illustrates distribution of the p-type impurity concentration of the p pillar region 16 in a depth direction (z direction). As illustrated in FIG. 3, the p-type impurity concentration of the p pillar region 16 in the depth direction is approximately constant.

A plurality of n⁻-type n pillar regions 18 is provided between the drain region 12 and the first plane. The n pillar region 18 is provided on the buffer region 14. The n pillar region 18 is provided between the p pillar regions 16.

The n pillar region 18 extends in the x direction, as illustrated in FIG. 2B. The n pillar region 18 has a flat plate shape parallel to the xz plane.

The n pillar region 18 contains n-type impurities. The n-type impurities are, for example, phosphorus (P).

The n-type impurity concentration of the n pillar region 18 is, for example, from 1 × 10¹⁵ cm⁻³ to 8 × 10¹⁶ cm⁻³, both inclusive. The n-type impurity concentration of the n pillar region 18 is approximately constant in the depth direction.

The n pillar region 18 functions as a current path at the time of an on operation of the MOSFET 100.

The p pillar region 16 and the n pillar region 18 are alternately arranged in a y direction. The p pillar region 16 and the n pillar region 18 form the SJ structure. With the SJ structure, the breakdown voltage is improved and the on-resistance is reduced in the MOSFET 100 A disposition pitch (d2 in FIG. 1) of the p pillar region 16 and the n pillar region 18 in the y direction is, for example, from 4 µm to 20 µm, both inclusive.

The p-type base region 20 is provided between the p pillar region 16 and the first plane. At least a part of the base region 20 is in contact with the first plane. The base region 20 extends in the x direction.

The base region 20 contains p-type impurities. The p-type impurities are, for example, boron (B). The p-type impurity concentration of the base region 20 is higher than the p-type impurity concentration of the p pillar region 16. The p-type impurity concentration is, for example, from 5 × 10¹⁶ cm⁻³ to 5 × 10¹⁸ cm⁻³, both inclusive.

An inversion layer is formed in a region of the base region 20, the region being right under the gate electrode 32, at the time of an on operation of the MOSFET 100. The inversion layer functions as a channel of the MOSFET 100.

The n⁺-type source region 22 is provided between the base region 20 and the first plane. The source region 22 extends in the x direction. The source region 22 contains n-type impurities. The n-type impurities are, for example, phosphorus (P). The n-type impurity concentration is, for example, from 1 × 10¹⁸ cm⁻³ to 1 × 10²² cm⁻³, both inclusive.

The source region 22 is electrically connected to the source electrode 38.

The p⁺-type contact region 24 is provided between the base region 20 and the first plane. The contact region 24 is provided adjacent to the source region 22. The contact region 24 extends in the x direction.

The contact region 24 contains p-type impurities. The p-type impurities are, for example, boron (B). The p-type impurity concentration is, for example, from 1 × 10¹⁸ cm⁻³ to 1 × 10²² cm⁻³, both inclusive.

The contact region 24 is electrically connected to the source electrode 38. The contact region 24 has a function to reduce a contact resistance between the semiconductor layer 10 and the source electrode 38.

The n-type JFET region 26 is provided between the n pillar region 18 and the first plane. At least a part of the JFET region 26 is in contact with the first plane. The JFET region 26 is sandwiched between the base regions 20.

The JFET region 26 contains n-type impurities. The n-type impurities are, for example, phosphorus (P). The n-type impurity concentration of the JFET region 26 is higher than the n-type impurity concentration of the n pillar region 18. The n-type impurity concentration is, for example, from 1 × 10¹⁵ cm⁻³ to 5 × 10¹⁷ cm⁻³, both inclusive.

The JFET region 26 functions as a current path at the time of an on operation of the MOSFET 100.

The n⁻⁻-type high-resistance region 30 is provided between the p pillar region 16 and the base region 20. An electric resistance per unit depth of the high-resistance region 30 is higher than an electric resistance per unit depth of the p pillar region 16. The unit depth is a direction from the first plane to the second plane, that is, a predetermined distance in a z direction in FIG. 1.

The high-resistance region 30 contains n-type impurities. The n-type impurities are, for example, phosphorus (P). The n-type impurity concentration is, for example, 1 × 10¹⁵ cm⁻³ or less.

The n-type impurity concentration of the high-resistance region 30 is lower than the n-type impurity concentration of the n pillar region 18. A length (d3 in FIG. 1) of the high-resistance region 30 in the depth direction (z direction) is, for example, equal to or less than one-tenth of the distance (d1 in FIG. 1) from an end portion of the p pillar region 16 on a side of the first plane to an end portion of the p pillar regions 16 on a side of the second plane.

The gate electrode 32 is provided on the first plane of the semiconductor layer 10. The gate electrode 32 is a conductive layer. The gate electrode 32 extends in the x direction. The gate electrode 32 is made of, for example, polycrystalline silicon containing n-type impurities or p-type impurities.

The gate insulating film 34 is provided between the gate electrode 32 and the semiconductor layer 10. The gate insulating film 34 is provided between the gate electrode 32 and a portion where the base region 20 is in contact with the first plane. The gate insulating film 34 is made of, for example, silicon oxide.

The interlayer insulating film 36 is provided on the gate electrode 32. The interlayer insulating film 36 is made of, for example, silicon oxide.

The source electrode 38 is in contact with the first plane of the semiconductor layer 10. The source electrode 38 is an opening provided in the interlayer insulating film 36 and is in contact with the first plane. The source electrode 38 is in contact with the source region 22 and the contact region 24. A contact between the source electrode 38, and the source region 22 and the contact region 24 is an ohmic contact.

The source electrode 38 is made of a metal. The source electrode 38 is, for example, a stacked film made of titanium (Ti) and aluminum (Al).

The drain electrode 40 is in contact with the second plane of the semiconductor layer 10. The drain electrode 40 is in contact with the drain region 12. A contact between the drain electrode 40 and the drain region 12 is an ohmic contact.

The impurity concentration and distribution of the impurity concentration in the semiconductor regions can be obtained using secondary ion mass spectroscopy (SIMS), for example.

The distribution of the impurity concentration and the magnitude relationship of the impurity concentration in the semiconductor regions can also be obtained using scanning capacitance microscopy (SCM), for example.

When comparing the magnitude of the impurity concentration between the semiconductor regions, for example, the impurity concentration in the vicinity of a center of each semiconductor region is regarded as the impurity concentration of the semiconductor region and compared.

Distances such as depths and widths of the semiconductor regions can be obtained by SIMS, for example. Further, the distances such depths and widths of the semiconductor regions can be obtained from a combined image of an SCM image and an atomic force microscope (AFM) image, for example.

Determination of the magnitude relationship between the electric resistance per unit depth of the high-resistance region 30 and the electric resistance per unit depth of the p pillar region 16 can be made by two-dimensionally measuring the distribution of the electric resistance, using scanning spreading resistance microscopy (SSRM). Further, the determination can be made by two-dimensionally measuring the distribution of the impurity concentration, using SCM.

Note that the SJ structure of the first embodiment can be formed by, for example, a so-called single epitaxial method in which a p-type semiconductor is buried in a trench formed in an n-type semiconductor region of the semiconductor layer 10, the trench being formed for formation of a p pillar region. Further, the SJ structure can also be formed by, for example, a so-called multi-epitaxial method in which formation of an n-type epitaxial layer and ion implantation of a p-type impurity are repeatedly performed a plurality of times.

The n⁻⁻-type high-resistance region 30 can be formed, for example, by ion implantation of n-type impurities into a region between the p pillar region 16 and the base region 20 after formation of the SJ structure. By the ion implantation of n-type impurities, the p-type impurities in the p pillar region 16 are compensated and converted into the n-type.

Next, functions and effects of the semiconductor device of the first embodiment will be described.

MOSFETs used in a power supply circuit such as a switching power supply is required to decrease the on-resistance and improve switching speed in response to the demand for downsizing of the power supply circuit. Improvement of the switching speed of the MOSFET enables reduction of the size of a passive device such as an inductance and a capacitance in the power supply circuit and realization of downsizing of the power supply circuit.

However, if the switching speed of the MOSFET is increased, noise at the time of a switching operation may be increased. In particular, in the MOSFET having the SJ structure, the drain-source capacitance (Cds) and the gate-drain capacitance (Cgd) are rapidly decreased as the n-type region and the p-type region are rapidly depleted at the time of turning off the MOSFET. Therefore, a temporal change amount (dv/dt) of a drain voltage and a temporal change amount (di/dt) of a drain current become large. As a result, counter electromotive force due to parasitic inductance and displacement current due to parasitic capacitance are generated, and the noise at the time of the switching operation is increased.

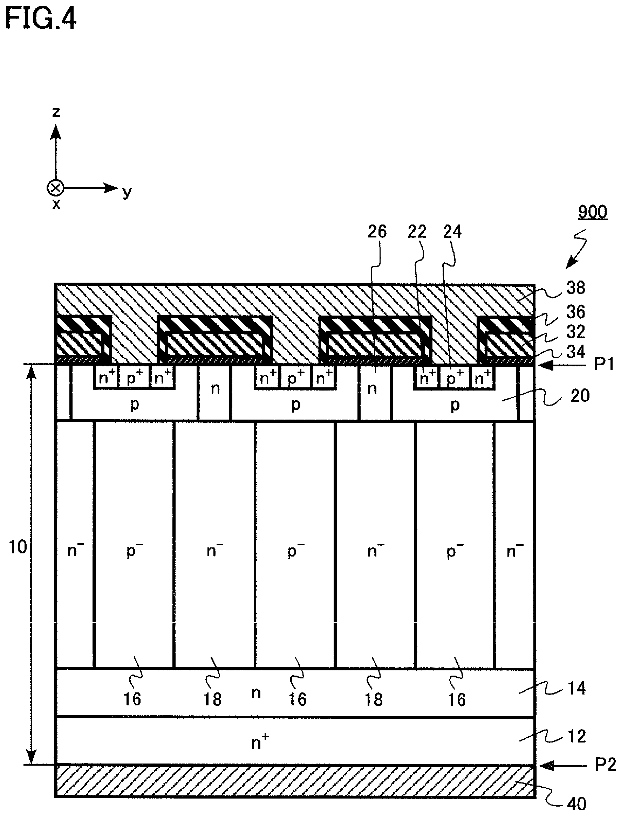

FIG. 4 is a schematic sectional view of a semiconductor device of a comparative example. The semiconductor device of the comparative example is a vertical MOSFET having an SJ structure. A MOSFET 900 of the comparative example is similar to the MOSFET 100 of the first embodiment except that the MOSFET 900 does not have an n⁻⁻-type high-resistance region 30.

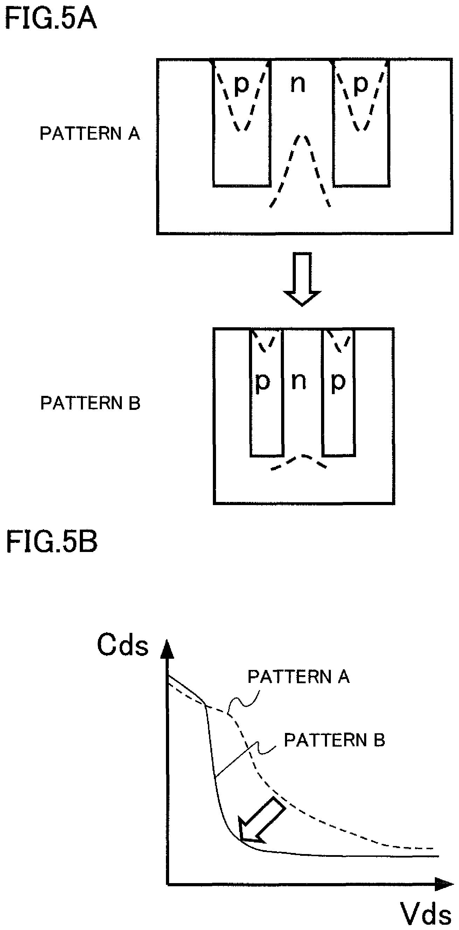

FIGS. 5A and 5B are explanatory diagrams of problems of the semiconductor device of the first embodiment. FIG. 5A is a schematic diagram of the SJ structure of the MOSFET 900 of the comparative example, and FIG. 5B is a diagram illustrating a relationship between a drain voltage (Vds) and a drain-source capacitance (Cds) of the MOSFET 900 of the comparative example.

To decrease the on-resistance of the MOSFET, scaling-down of a pitch of the SJ structure to decrease the on-resistance per unit area is conceivable. For example, consider a case of changing a pattern A in FIG. 5A to a pattern B in which the pitch of the SJ structure is halved to decrease the on-resistance. FIGS. 5A and 5B schematically illustrates a depleted state of the SJ structure by dotted lines.

When changing the pattern from the pattern A to the scaled-down pattern B, the drain-source capacitance (Cds) is sharply decreased with respect to the drain voltage (Vds), as illustrated in FIG. 5B. This is because the SJ structure is more rapidly depleted as the pitch of the SJ structure becomes smaller. Therefore, if the pitch of the SJ structure is scaled down, there is a further concern about an increase in noise.

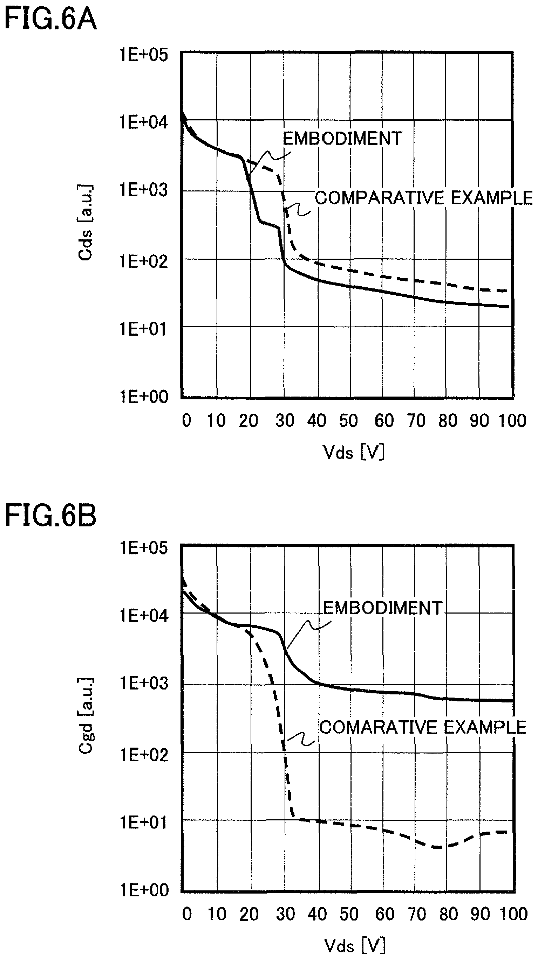

FIGS. 6A and 6B are explanatory diagrams of functions and effects of the semiconductor device of the first embodiment. FIG. 6A is a diagram illustrating simulation results of the relationship between the drain voltage (Vds) and the drain-source capacitance (Cds), of the MOSFET 100 of the first embodiment and the MOSFET 900 of the comparative example. FIG. 6B is a diagram illustrating simulation results of the relationship between the drain voltage (Vds) and the gate-drain capacitance (Cgd), of the MOSFET 100 of the first embodiment and the MOSFET 900 of the comparative example.

As is clear from FIGS. 6A and 6B, in the case of the MOSFET 100 of the first embodiment, change of the drain-source capacitance (Cds) and the gate-drain capacitance (Cgd) with respect to the drain voltage (Vds) is gentle, as compared with the MOSFET 900 of the comparative example. This is because a depletion speed of the SJ structure at the time of turning off the MOSFET 100 is alleviated with the provision of the n⁻⁻-type high-resistance region 30. More specifically, this is because an extraction speed of holes from the p pillar region 16 at the time of turn-off to the source electrode 38 is alleviated due to the existence of the n⁻⁻-type high-resistance region 30.

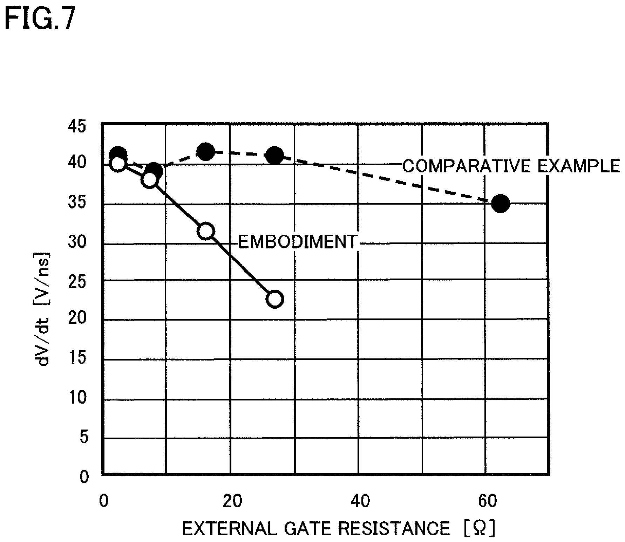

FIG. 7 is an explanatory diagram of functions and effects of the semiconductor device of the first embodiment. FIG. 7 is a diagram illustrating simulation results of a temporal change amount (dv/dt) of the drain voltage, of the MOSFET 100 of the first embodiment and the MOSFET 900 of the comparative example.

As is clear from FIG. 7, in the case of the MOSFET 100 of the first embodiment, the temporal change amount (dv/dt) of the drain voltage is decreased as compared with the MOSFET 900 of the comparative example. This is because, in the case of the MOSFET 100 as illustrated in FIG. 6, change of the drain-source capacitance (Cds) and the gate-drain capacitance (Cgd) with respect to the drain voltage (Vds) is gentle. Therefore, according to the MOSFET 100 of the first embodiment, the noise at the time of a switching operation can be suppressed.

Further, as is clear from FIG. 7, dependency of the temporal change amount (dv/dt) of the drain voltage on the external gate resistance is increased. Therefore, in the MOSFET 100 of the first embodiment, adjustment of balance between improvement of the switching speed of the MOSFET 100 and suppression of the noise becomes easy by adjustment of the external gate resistance.

According to the MOSFET 100 of the first embodiment, the noise at the time of the switching operation can be suppressed, and thus a decrease in the on-resistance per unit area due to reduction of the pitch of the SJ structure can also be easily realized.

The distance (d1 in FIG. 1) from an end portion of the p pillar region 16 on a side of the first plane to an end portion of the p pillar region 16 on a side of the second plane depends on a desired breakdown voltage. For example, the distance is favorably 20 µm or more in order to obtain a breakdown voltage of 250 V or more, and the distance is favorably 30 µm or more in order to obtain a breakdown voltage of 600 V or more. The desired breakdown voltage may not be able to be realized if the distance falls below the above range.

The disposition pitch (d2 in FIG. 1) of the p pillar region 16 and the n pillar region 18 in the y direction is favorably from 4 µm to 20 µm, both inclusive, and more favorably from 5 µm to 10 µm, both inclusive. The desired breakdown voltage may not be able to be realized if the arrangement pitch falls below the above range. The on-resistance per unit area may be increased if the arrangement pitch exceeds the above range.

The length (d3 in FIG. 1) of the high-resistance region 30 in the depth direction (z direction) is favorably equal to or less than one-tenth of the distance (d1 in FIG. 1) from an end portion of the p pillar region 16 on a side of the first plane to an end portion of the p pillar regions 16 on a side of the second plane. Charge balance of the SJ structure may collapse and the breakdown voltage may be decreased if the length exceeds the above range.

According to the MOSFET 100 of the first embodiment, the noise at the time of the switching operation can be suppressed. In addition, adjustment of balance between improvement of the switching operation and suppression of the noise becomes easy. In addition, a decrease in the on-resistance per unit area by reduction of the pitch of the SJ structure becomes easy.

### (Second Embodiment)

A semiconductor device of a second embodiment is similar to that of the first embodiment except that a sixth semiconductor region is of a second conductivity type, and second conductivity-type impurity concentration of the sixth semiconductor region is lower than second conductivity-type impurity concentration of a second semiconductor region. Hereinafter, content of description overlapping with the first embodiment will be partially omitted.

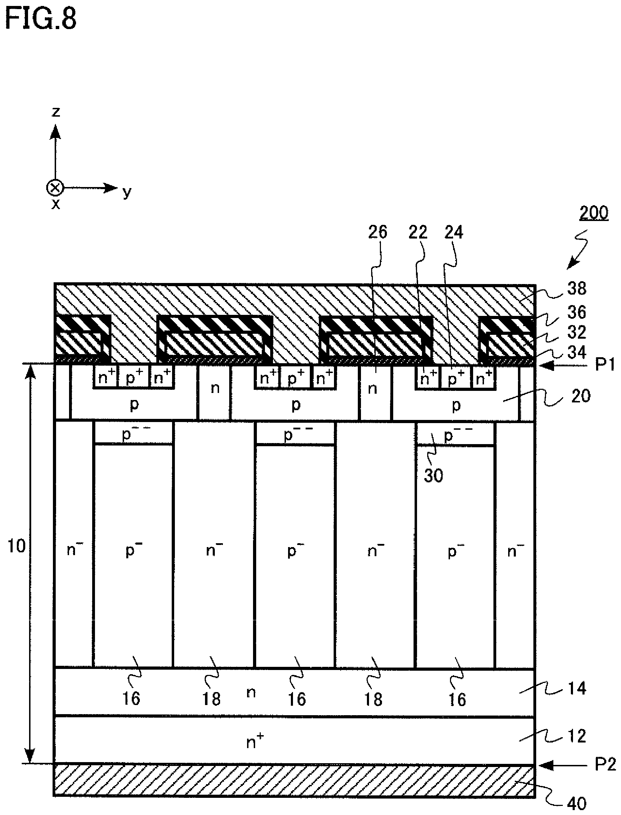

FIG. 8 is a schematic sectional view of the semiconductor device of the second embodiment. The semiconductor device of the second embodiment is a vertical MOSFET 200 having an SJ structure.

The MOSFET 200 includes a semiconductor layer 10, an n⁺-type drain region 12 (first semiconductor region), an n-type buffer region 14, a p⁻-type p pillar region 16 (second semiconductor region), an n⁻-type n pillar region 18 (third semiconductor region), a p-type base region 20 (fourth semiconductor region), an n⁺-type source region 22 (fifth semiconductor region), a p⁺-type contact region 24, an n-type JFET region 26, an p⁻⁻-type high-resistance region 30 (sixth semiconductor region), a gate electrode 32, a gate insulating film 34, an interlayer insulating film 36, a source electrode 38, and a drain electrode 40.

The p⁻⁻-type high-resistance region 30 is provided between the p pillar region 16 and the base region 20. An electric resistance per unit depth of the high-resistance region 30 is higher than an electric resistance per unit depth of the p pillar region 16.

The high-resistance region 30 contains p-type impurities. The p-type impurities are, for example, boron (B). The p-type impurity concentration is, for example, 1 × 10¹⁵ cm⁻³ or less.

The p-type impurity concentration of the high-resistance region 30 is lower than the p-type impurity concentration of the p pillar region 16.

The p⁻⁻-type high-resistance region 30 can be formed, for example, by ion implantation of n-type impurities into a region between the p pillar region 16 and the base region 20 after formation of the SJ structure. By the ion implantation of n-type impurities, the p-type impurities in the p pillar region 16 are compensated and the p-type impurity concentration is decreased.

According to the MOSFET 200 of the second embodiment, noise at the time of a switching operation can be suppressed, similarly to the first embodiment. In addition, adjustment of balance between improvement of the switching operation and suppression of the noise becomes easy. In addition, a decrease in the on-resistance per unit area by reduction of the pitch of the SJ structure becomes easy.

### (Third Embodiment)

A semiconductor device of a third embodiment is similar to that of the first embodiment except that a sixth semiconductor region is of a second conductivity type, and the width of the sixth semiconductor region is narrower than the width of a second semiconductor region. Hereinafter, content of description overlapping with the first embodiment will be partially omitted.

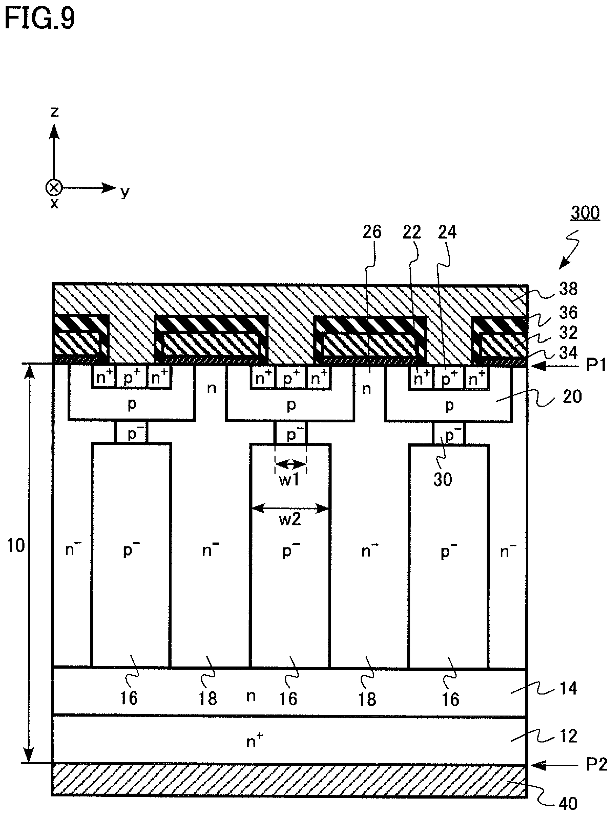

FIG. 9 is a schematic sectional view of the semiconductor device of the third embodiment. The semiconductor device of the third embodiment is a vertical MOSFET 300 having an SJ structure.

The MOSFET 300 includes a semiconductor layer 10, an n⁺-type drain region 12 (first semiconductor region), an n-type buffer region 14, a p⁻-type p pillar region 16 (second semiconductor region), an n⁻-type n pillar region 18 (third semiconductor region), a p-type base region 20 (fourth semiconductor region), an n⁺-type source region 22 (fifth semiconductor region), a p⁺-type contact region 24, an n-type JFET region 26, a p⁻-type high-resistance region 30 (sixth semiconductor region), a gate electrode 32, a gate insulating film 34, an interlayer insulating film 36, a source electrode 38, and a drain electrode 40.

The p⁻-type high-resistance region 30 is provided between the p pillar region 16 and the base region 20. An electric resistance per unit depth of the high-resistance region 30 is higher than an electric resistance per unit depth of the p pillar region 16.

The width of the high-resistance region 30 in a y direction (w1 in FIG. 9) is narrower than the width of the p pillar region 16 in the y direction (w2 in FIG. 9). The width of the high-resistance region 30 in the y direction (w1 in FIG. 9) is equal to or less than one-half of the width of the p pillar region 16 in the y direction (w2 in FIG. 9).

The high-resistance region 30 contains p-type impurities. The p-type impurities are, for example, boron (B).

The p-type impurity concentration of the high-resistance region 30 is, for example, approximately the same as the p-type impurity concentration of the p pillar region 16. The p-type impurity concentration is, for example, from 5 × 10¹⁴ cm⁻³ to 1 × 10¹⁶ cm⁻³, both inclusive.

The p⁻-type high-resistance region 30 can be formed, for example, by ion implantation of n-type impurities into a region between the p pillar region 16 and the base region 20 and is a region where no high-resistance region 30 is formed after formation of the SJ structure. By the ion implantation of n-type impurities, the p-type impurities in the p pillar region 16 are compensated and the region other than the high-resistance region 30 is converted into the n-type.

The width of the high-resistance region 30 in the y direction (w1 in FIG. 9) is favorably equal to or less than one-half of the width of the p pillar region 16 in the y direction (w2 in FIG. 9). The effect to suppress noise at the time of a switching operation may be insufficient if the width exceeds the above range.

According to the MOSFET 300 of the third embodiment, the noise at the time of a switching operation can be suppressed, similarly to the first embodiment. In addition, adjustment of balance between improvement of the switching operation and suppression of the noise becomes easy. In addition, a decrease in the on-resistance per unit area by reduction of the pitch of the SJ structure becomes easy.

### (Fourth Embodiment)

A semiconductor device of a fourth embodiment is similar to that of the first embodiment except that second conductivity-type impurity concentration of a second semiconductor region is monotonously decreased from an end portion on a side of a first plane to an end portion on a side of a second plane. Hereinafter, content of description overlapping with the first embodiment will be partially omitted.

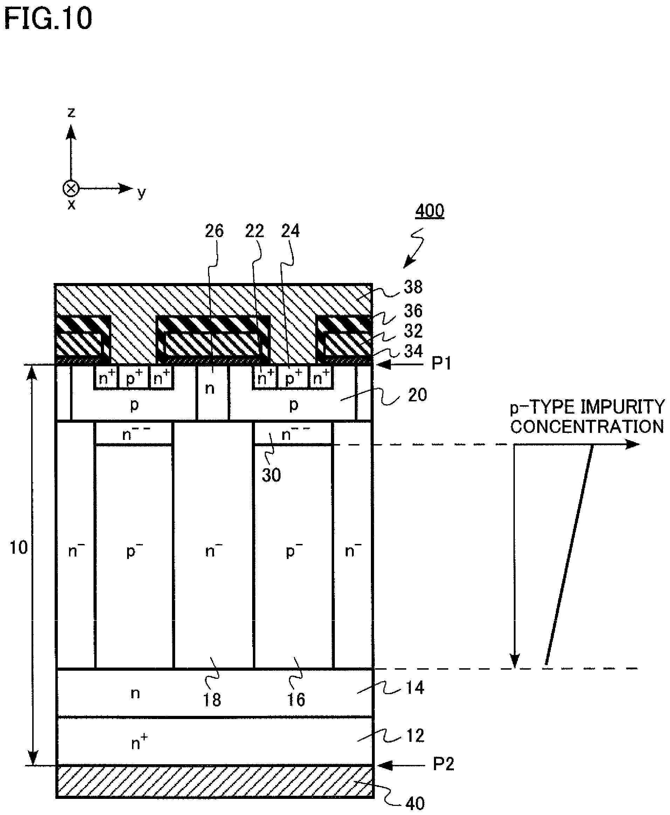

FIG. 10 is a schematic sectional view of the semiconductor device of the fourth embodiment. The semiconductor device of the fourth embodiment is a vertical MOSFET 400 having an SJ structure. FIG. 10 also illustrates distribution of p-type impurity concentration of the semiconductor device of the fourth embodiment.

The MOSFET 400 includes a semiconductor layer 10, an n⁺-type drain region 12 (first semiconductor region), an n-type buffer region 14, a p⁻-type p pillar region 16 (second semiconductor region), an n⁻-type n pillar region 18 (third semiconductor region), a p-type base region 20 (fourth semiconductor region), an n⁺-type source region 22 (fifth semiconductor region), a p⁺-type contact region 24, an n-type JFET region 26, an n⁻⁻-type high-resistance region 30 (sixth semiconductor region), a gate electrode 32, a gate insulating film 34, an interlayer insulating film 36, a source electrode 38, and a drain electrode 40.

As illustrated in FIG. 10, the p-type impurity concentration of the p pillar region 16 is monotonously decreased from an end portion of the p pillar region 16 on a side of the first plane to an end portion of the p pillar region 16 on a side of the second plane.

A maximum value of the p-type impurity concentration of the p pillar region 16 is, for example, five times or less of a minimum value of the p-type impurity concentration of the p pillar region 16.

Distribution of the p-type impurity concentration of the p⁻-type p pillar region 16 of the MOSFET 400 can be formed by, for example, forming a trench into a forward tapered shape, the trench being used in forming the p pillar region 16 by a single epitaxial method.

According to the MOSFET 400 of the fourth embodiment, noise at the time of a switching operation can be suppressed, similarly to the first embodiment. In addition, adjustment of balance between improvement of the switching operation and suppression of the noise becomes easy. In addition, a decrease in the on-resistance per unit area by reduction of the pitch of the SJ structure becomes easy.

### (Fifth Embodiment)

A semiconductor device of a fifth embodiment is similar to that of the first embodiment except that an n⁺-type intermediate region is further provided between an n pillar region 18 and an n-type JFET region 26. Hereinafter, content of description overlapping with the first embodiment will be partially omitted.

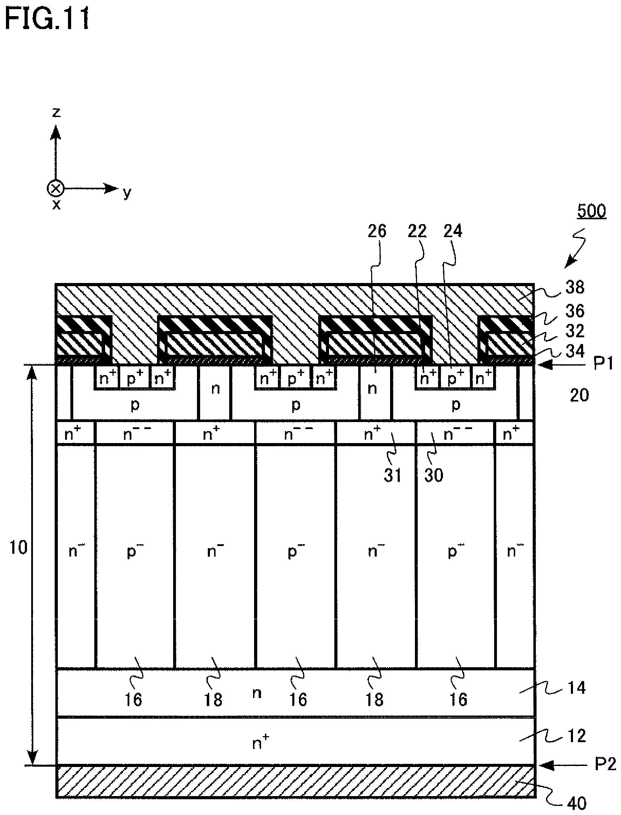

FIG. 11 is a schematic sectional view of the semiconductor device of the fifth embodiment. The semiconductor device of the fifth embodiment is a vertical MOSFET 500 having an SJ structure.

The MOSFET 500 includes a semiconductor layer 10, an n⁺-type drain region 12 (first semiconductor region), an n-type buffer region 14, a p⁻-type p pillar region 16 (second semiconductor region), an n⁻-type n pillar region 18 (third semiconductor region), a p-type base region 20 (fourth semiconductor region), an n⁺-type source region 22 (fifth semiconductor region), a p⁺-type contact region 24, an n-type JFET region 26, an n⁻⁻-type high-resistance region 30 (sixth semiconductor region), an n⁺-type intermediate region 31, a gate electrode 32, a gate insulating film 34, an interlayer insulating film 36, a source electrode 38, and a drain electrode 40.

The n⁺-type intermediate region 31 contains n-type impurities. The n-type impurity concentration of the intermediate region 31 is higher than the n-type impurity concentration in the n pillar region 18. The n-type impurity concentration of the intermediate region 31 is higher than the n-type impurity concentration in the JFET region 26.

The n-type impurities are, for example, phosphorus (P). The n-type impurity concentration is, for example, from 5 × 10¹⁵ cm⁻³ to 5 × 10¹⁷ cm⁻³, both inclusive.

The intermediate region 31 functions as a current path at the time of an on operation of the MOSFET 500.

The n⁺-type intermediate region 31 can be formed by performing ion implantation of an n-type impurity into between the n pillar region 18 and the JFET region 26 at the same time with ion implantation in forming the n⁻⁻-type high-resistance region 30.

According to the MOSFET 500 of the fifth embodiment, noise at the time of a switching operation can be suppressed, similarly to the first embodiment. In addition, adjustment of balance between improvement of the switching operation and suppression of the noise becomes easy. In addition, a decrease in the on-resistance per unit area by reduction of the pitch of the SJ structure becomes easy.

### (Sixth Embodiment)

A semiconductor device according to a sixth embodiment is different from that of the first embodiment in further including a seventh semiconductor region provided between a sixth semiconductor region and a fourth semiconductor region, and having a lower second conductivity-type impurity concentration than the fourth semiconductor region, and in that an electric resistance per unit depth of the sixth semiconductor region is higher than an electric resistance per unit depth of the seventh semiconductor region. Hereinafter, content of description overlapping with the first embodiment will be partially omitted.

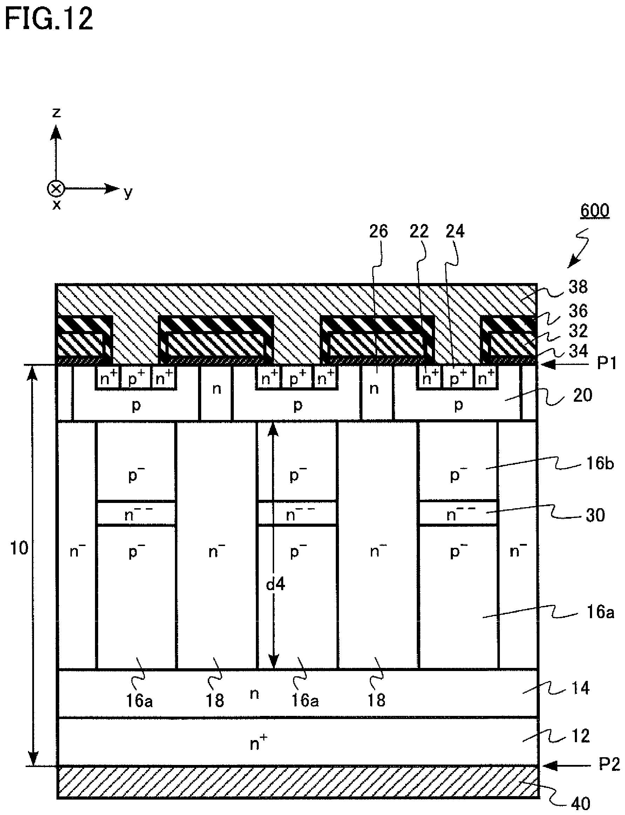

FIG. 12 is a schematic sectional view of the semiconductor device of the sixth embodiment. The semiconductor device of the sixth embodiment is a vertical MOSFET 600 having an SJ structure.

The MOSFET 600 includes a semiconductor layer 10, an n⁺-type drain region 12 (first semiconductor region), an n-type buffer region 14, a p⁻-type lower p pillar region 16a (second semiconductor region), a p⁻-type upper p pillar region 16b (seventh semiconductor region), an n⁻-type n pillar region 18 (third semiconductor region), a p-type base region 20 (fourth semiconductor region), an n⁺-type source region 22 (fifth semiconductor region), a p⁺-type contact region 24, an n-type JFET region 26, an n⁻⁻-type high-resistance region 30 (sixth semiconductor region), a gate electrode 32, a gate insulating film 34, an interlayer insulating film 36, a source electrode 38, and a drain electrode 40.

The plurality of p⁻-type lower p pillar regions 16a is provided between the drain region 12 and the first plane. The lower p pillar region 16a is provided on the buffer region 14. The lower p pillar region 16a extends in the x direction. The lower p pillar region 16a has a flat plate shape parallel to the xz plane.

The lower p pillar region 16a contains p-type impurities. The p-type impurities are, for example, boron (B). The p-type impurity concentration is, for example, from 1 × 10¹⁵ cm⁻³ to 5 × 10¹⁷ cm⁻³, both inclusive.

The plurality of p⁻-type upper p pillar regions 16b is provided between the drain region 12 and the first plane. The upper p pillar region 16b is provided between the n⁻⁻-type high-resistance region 30 and the p-type base region 20. The upper p pillar region 16b extends in the x direction. The upper p pillar region 16b has a flat plate shape parallel to the xz plane.

The upper p pillar region 16b contains p-type impurities. The p-type impurities are, for example, boron (B).

The p-type impurity concentration of the upper p pillar region 16b is lower than the p-type impurity concentration of the base region 20. The p-type impurity concentration is, for example, from 1 × 10¹⁵ cm⁻³ to 5 × 10¹⁷ cm⁻³, both inclusive.

The pillar region of the MOSFET 600 is configured from the lower p pillar region 16a and the upper p pillar region 16b. The n⁻⁻-type high-resistance region 30 is sandwiched between the lower p pillar region 16a and the upper p pillar region 16b.

A distance (d4 in FIG. 12) from an end portion of the upper p pillar region 16b on a side of the first plane to an end portion of the lower p pillar region 16a on a side of the second plane is, for example, 20 µm or more.

An electric resistance per unit depth of the n⁻⁻-type high-resistance region 30 is higher than electric resistances per unit depth of the lower p pillar region 16a and the upper p pillar region 16b.

The high-resistance region 30 contains n-type impurities. The n-type impurities are, for example, phosphorus (P). The n-type impurity concentration is, for example, 1 × 10¹⁵ cm⁻³ or less.

The n-type impurity concentration of the high-resistance region 30 is lower than the n-type impurity concentration of the n pillar region 18.

The n⁻⁻-type high-resistance region 30 can be formed, for example, by reducing the p-type impurity amount to be implanted into a part of an epitaxial layer in forming an SJ structure by a multi-epitaxial method.

According to the MOSFET 600 of the sixth embodiment, noise at the time of a switching operation can be suppressed, similarly to the first embodiment. In addition, adjustment of balance between improvement of the switching operation and suppression of the noise becomes easy. In addition, a decrease in the on-resistance per unit area by reduction of the pitch of the SJ structure becomes easy.

### (Seventh Embodiment)

A semiconductor device of a seventh embodiment is similar to that of the sixth embodiment except that a sixth semiconductor region is of a second conductivity type, and second conductivity-type impurity concentration of the sixth semiconductor region is lower than second conductivity-type impurity concentration of a seventh semiconductor region. Hereinafter, content of description overlapping with the sixth embodiment will be partially omitted.

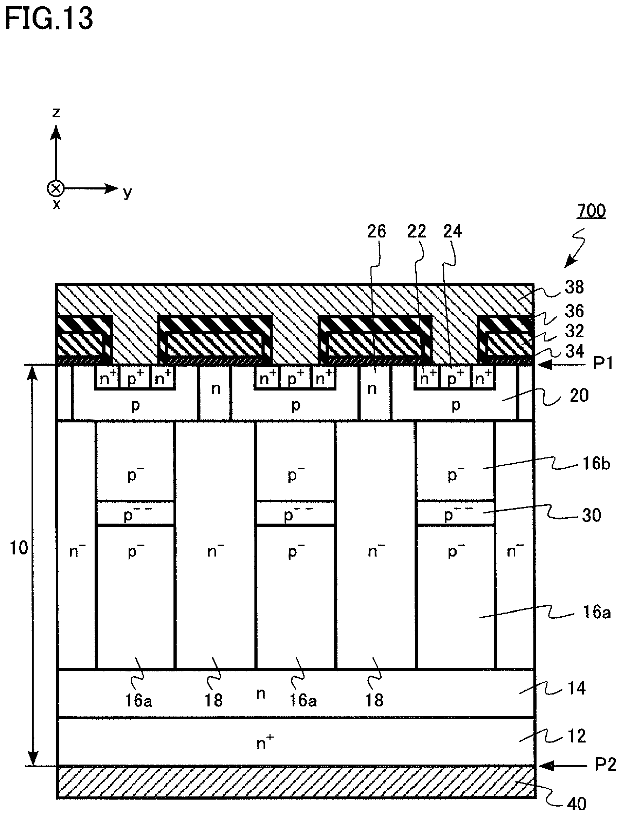

FIG. 13 is a schematic sectional view of the semiconductor device of the seventh embodiment. The semiconductor device of the seventh embodiment is a vertical MOSFET 700 having an SJ structure.

The MOSFET 700 includes a semiconductor layer 10, an n⁺-type drain region 12 (first semiconductor region), an n-type buffer region 14, a p⁻-type lower p pillar region 16a (second semiconductor region), a p⁻-type upper p pillar region 16b (seventh semiconductor region), an n⁻-type n pillar region 18 (third semiconductor region), a p-type base region 20 (fourth semiconductor region), an n⁺-type source region 22 (fifth semiconductor region), a p⁺-type contact region 24, an n-type JFET region 26, a p⁻⁻-type high-resistance region 30 (sixth semiconductor region), a gate electrode 32, a gate insulating film 34, an interlayer insulating film 36, a source electrode 38, and a drain electrode 40.

The pillar region of the MOSFET 700 is configured from the lower p pillar region 16a and the upper p pillar region 16b. The p⁻⁻-type high-resistance region 30 is sandwiched between the lower p pillar region 16a and the upper p pillar region 16b.

An electric resistance per unit depth of the p⁻⁻-type high-resistance region 30 is higher than electric resistances per unit depth of the lower p pillar region 16a and the upper p pillar region 16b.

The high-resistance region 30 contains p-type impurities. The p-type impurities are, for example, boron (B). The p-type impurity concentration is, for example, 1 × 10¹⁵ cm⁻³ or less.

The p type impurity concentration of the high-resistance region 30 is lower than the p type impurity concentrations of the lower p pillar region 16a and the upper p pillar region 16b.

The p⁻⁻-type high-resistance region 30 can be formed, for example, by reducing the p-type impurity amount to be implanted into a part of an epitaxial layer in forming an SJ structure by a multi-epitaxial method.

Note that a plurality of the high-resistance regions 30 can be configured to be sandwiched between pillar regions.

According to the MOSFET, 700 of the seventh embodiment, noise at the time of a switching operation can be suppressed, similarly to the sixth embodiment. In addition, adjustment of balance between improvement of the switching operation and suppression of the noise becomes easy. In addition, a decrease in the on-resistance per unit area by reduction of the pitch of the SJ structure becomes easy.

### (Eighth Embodiment)

A semiconductor device of an eighth embodiment is similar to that of the sixth embodiment except that a sixth semiconductor region is of a second conductivity type, and the width of the sixth semiconductor region is narrower than the width of a second semiconductor region and the width of a seventh semiconductor region. Hereinafter, content of description overlapping with the sixth embodiment will be partially omitted.

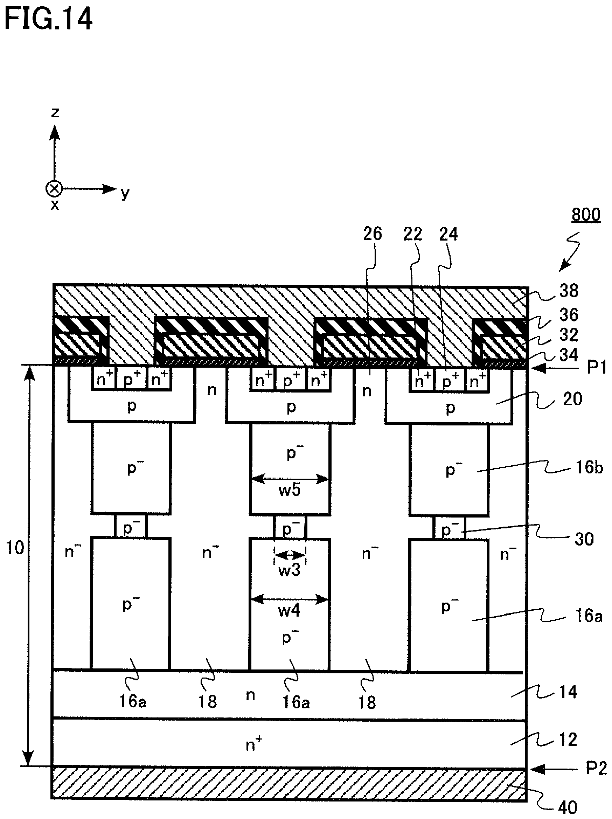

FIG. 14 is a schematic sectional view of the semiconductor device of the eighth embodiment. The semiconductor device of the eighth embodiment is a vertical MOSFET 800 having an SJ structure.

The MOSFET 800 includes a semiconductor layer 10, an n⁺-type drain region 12 (first semiconductor region), an n-type buffer region 14, a p⁻-type lower p pillar region 16a (second semiconductor region), a p⁻-type upper p pillar region 16b (seventh semiconductor region), an n⁻-type n pillar region 18 (third semiconductor region), a p-type base region 20 (fourth semiconductor region), an n⁺-type source region 22 (fifth semiconductor region), a p⁺-type contact region 24, an n-type JFET region 26, a p⁻-type high-resistance region 30 (sixth semiconductor region), a gate electrode 32, a gate insulating film 34, an interlayer insulating film 36, a source electrode 38, and a drain electrode 40.

The pillar region of the MOSFET 800 is configured from the lower p pillar region 16a and the upper p pillar region 16b. The p⁻-type high-resistance region 30 is sandwiched between the lower p pillar region 16a and the upper p pillar region 16b.

An electric resistance per unit depth of the p⁻-type high-resistance region 30 is higher than electric resistances per unit depth of the lower p pillar region 16a and the upper p pillar region 16b.

The high-resistance region 30 contains p-type impurities. The width of the high-resistance region 30 in a y direction (w3 in FIG. 14) is narrower than the width of the lower p pillar region 16a in the y direction (w4 in FIG. 14) and the width of the upper p pillar region 16b in the y direction (w5 in FIG. 14). For example, the width of the high-resistance region 30 in the y direction (w3 in FIG. 14) is equal to or less than one-half of the width of the lower p pillar region 16a in the y direction (w4 in FIG. 14) and the width of the upper p pillar region 16b in the y direction (w5 in FIG. 14).

The p-type impurities are, for example, boron (B). The p-type impurity concentration is, for example, from 5 × 10¹⁴ cm⁻³ to 1 × 10¹⁶ cm⁻³, both inclusive.

The p-type impurity concentration of the high-resistance region 30 is, for example, approximately the same as the p-type impurity concentrations of the lower p pillar region 16a and the upper p pillar region 16b.

The p⁻-type high-resistance region 30 can be formed by providing in advance a region having high n-type impurity concentration in a layer manner parallel to an xy plane, in a place in the semiconductor layer 10, where the high-resistance region 30 is to be formed, in forming an SJ structure by a single epitaxial method. That is, in the place where the high-resistance region 30 is to be formed, a region having high n-type impurity concentration is positioned at a side face of a p-type semiconductor buried in a trench for formation of the p pillar region. The high-resistance region 30 can be formed by diffusing the n-type impurities by thermal diffusion to narrow the width of the p pillar region.

According to the MOSFET 800 of the eighth embodiment, noise at the time of a switching operation can be suppressed, similarly to the sixth embodiment. In addition, adjustment of balance between improvement of the switching operation and suppression of the noise becomes easy. In addition, a decrease in the on-resistance per unit area by reduction of the pitch of the SJ structure becomes easy.

In the embodiments, the case where the semiconductor layer 10 is made of silicon has been described as an example. However, the semiconductor layer 10 may be another semiconductor such as an SiC or GaN-based semiconductor.

Further, in the embodiments, the case where the first conductivity type is the n type and the second conductivity type is the p type has been described as an example. However, the first conductivity type may be the p type and the second conductivity type may be the n type. In that case, the MOSFET is a p-type MOSFET having holes as carriers.

Further, in the embodiments, the case where the high-resistance region 30 is the n-type semiconductor or the p-type semiconductor has been described as an example. However, the high-resistance region 30 may be an intrinsic semiconductor.

Further, in the embodiments, the case where the p pillar region 16 and the n pillar region 18 configuring the SJ structure extend in the x direction, that is, in the same direction as the gate electrode has been described as an example. However, the p pillar regions 16 and n pillar region 18 may extend in the y direction, that is, in a direction orthogonal to the gate electrode.

Further, in the embodiments, the case where the p pillar region 16 and the n pillar region 18 forming the SJ structure extend in the x direction, that is, in the same direction as the gate electrode has been described as an example. However, the p pillar region 16 functions as the SJ structure even if the p pillar region 16 is disposed on the xy plane in a dot manner as long as the charge balance with the n pillar region 18 is not impaired.

While certain embodiments have been described, these embodiments have been presented by way of example only, and are not intended to limit the scope of the inventions. Indeed, the semiconductor device described herein may be embodied in a variety of other forms; furthermore, various omissions, substitutions and changes in the form of the devices and methods described herein may be made without departing from the spirit of the inventions. The accompanying claims and their equivalents are intended to cover such forms or modifications as would fall within the scope and spirit of the inventions.

## Claims

1. A semiconductor device (100) comprising:
a semiconductor layer (10) having a first plane (P1) and a second plane (P2);
a first semiconductor region (12) of a first conductivity type provided in the semiconductor layer (10);
second semiconductor regions (16) of a second conductivity type provided between the first semiconductor region (12) and the first plane (P1);
third semiconductor regions (18) of the first conductivity type provided between the first semiconductor region (12) and the first plane (P1), and the third semiconductor regions (18) provided between the second semiconductor regions (16), the third semiconductor regions (18) and the second semiconductor regions (16) being alternately arranged;
a fourth semiconductor region (20) of the second conductivity type provided between at least one of the second semiconductor regions (16) and the first plane (P1), the fourth semiconductor region (20) having at least a part provided in contact with the first plane (P1), and the fourth semiconductor region (20) having a higher second conductivity-type impurity concentration than the second semiconductor regions (16);
a fifth semiconductor region (22) of the first conductivity type provided between the fourth semiconductor region (20) and the first plane (P1);
a sixth semiconductor region (30) provided between the at least one of the second semiconductor regions (16) and the fourth semiconductor region (20), and the sixth semiconductor region (30) having a higher electric resistance per unit depth than the second semiconductor regions (16);
a gate electrode (32); and
a gate insulating film (34) provided between the at least part of the fourth semiconductor region (20) and the gate electrode (32).

2. The semiconductor device according to claim 1, wherein the sixth semiconductor region (30) is of the first conductivity type, and a first conductivity-type impurity concentration of the sixth semiconductor region (30) is lower than a first conductivity-type impurity concentration of the third semiconductor regions (18).

3. The semiconductor device according to claim 1, wherein the sixth semiconductor region (30) is of the second conductivity type, and a second conductivity-type impurity concentration of the sixth semiconductor region (30) is lower than a second conductivity-type impurity concentration of the second semiconductor regions (16).

4. The semiconductor device according to claim 1, wherein the sixth semiconductor region (30) is of the second conductivity type, and a width of the sixth semiconductor region (30) is narrower than a width of the second semiconductor regions (16).

5. The semiconductor device according to any one of claims 1 to 4, wherein a distance from an end portion of the second semiconductor regions (16) on a side of the first plane (P1) to an end portion of the second semiconductor regions (16) on a side of the second plane (P2) is 20 µm or more.

6. The semiconductor device according to any one of claims 1 to 5, wherein a second conductivity-type impurity concentration of the second semiconductor regions (16) in a depth direction is approximately constant.

7. The semiconductor device according to any one of claims 1 to 5, wherein a second conductivity-type impurity concentration of the second semiconductor regions (16) is monotonously decreased from an end portion of the second semiconductor regions (16) on a side of the first plane (P1) to an end portion of the second semiconductor regions (16) on a side of the second plane (P2).

8. The semiconductor device according to claim 1, further comprising:
a seventh semiconductor region (16b) of the second conductivity type provided between the sixth semiconductor region (30) and the fourth semiconductor region (20), and the seventh semiconductor region (16b) having a lower second conductivity-type impurity concentration than the fourth semiconductor region (20), wherein
an electric resistance per unit depth of the sixth semiconductor region (30) is higher than an electric resistance per unit depth of the seventh semiconductor region (16b).

9. The semiconductor device according to claim 8, wherein the sixth semiconductor region (30) is of the first conductivity type, and a first conductivity-type impurity concentration of the sixth semiconductor region (30) is lower than the first conductivity-type impurity concentration of the third semiconductor regions (18).

10. The semiconductor device according to claim 8, wherein the sixth semiconductor region (30) is of the second conductivity type, and a second conductivity-type impurity concentration of the sixth semiconductor region (30) is lower than a second conductivity-type impurity concentration of the seventh semiconductor region (16b).

11. The semiconductor device according to claim 8, wherein the sixth semiconductor region (30) is of the second conductivity type, and a width of the sixth semiconductor region (30) is narrower than a width of the second semiconductor regions (16a) and a width of the seventh semiconductor region (16b).

12. The semiconductor device according to any one of claims 8 to 11, wherein a distance from an end portion of the seventh semiconductor region (16b) on a side of the first plane (P1) to an end portion of the second semiconductor regions (16a) on a side of the second plane (P2) is 20 µm or more.
